# EUROPÄISCHE PATENTSCHRIFT

(11) **EP 0 650 317 B1**
(45) Veröffentlichungstag und Bekanntmachung des Hinweises auf die Patenterteilung: **27.01.1999**
(21) Anmeldenummer: 94203016.4
(22) Anmeldetag: 17.10.1994
(51) Int. Cl.: H05K 7/14, H05K 9/00

(54) **Baugruppenträger**
Electronic rack
Rack électronique

(30) Priorität: 22.10.1993 DE 4336071
(43) Veröffentlichungstag der Anmeldung: 26.04.1995
(73) Patentinhaber: LUCENT TECHNOLOGIES INC., Murray Hill, New Jersey 07974-0636 (US)
(72) Erfinder: Wolf, Roland, D-20097 Hamburg (DE); Schimpl, Peter, D-20097 Hamburg (DE); Seitz, Reinhold, D-20097 Hamburg (DE)
(74) Vertreter: Johnston, Kenneth Graham

(56) Entgegenhaltungen:
- EP-A- 0 315 798
- WO-A-93/15595
- DE-C- 4 223 322

## Beschreibung

Die Erfindung bezieht sich auf einen Baugruppenträger mit zwei Seitenwänden und mit zwischen den Seitenwänden angeordneten, mit Querprofilschienen verbundenen Wabenblechen.

Bekannte Baugruppenträger dieser Art bestehen in der Regel aus zwei Seitenwänden, die durch eine Reihe von Querprofilschienen fest miteinander verbunden sind. Die einfachste Form eines derartigen Baugruppenträgers besteht aus zwei Seitenwänden und aus zwei vorderen und zwei hinteren Querprofilschienen. Jeweils eine vordere und eine hintere Profilschiene sind dabei durch parallel zu den Seitenwänden verlaufende Führungsschienen miteinander verbunden, die zur Aufnahme von parallel zu den Seitenwänden einschiebbaren Funktionseinheiten, z.B. Leiterplatten, dienen. Eine derartige Bauart ist z.B. durch die DE-PS 41 20 873 bekannt geworden. Dabei sind die Führungsschienen an ihrer Oberseite jeweils mit Führungsnuten zur Aufnahme der genannten Leiterplatten versehen. Die Führungsschienen werden mittels Zapfen in Bohrungen der Querprofilschienen eingesteckt und über federnde Zungen an den Querprofilschienen verrastet.

Es ist bekannt, sogenannte Wabenbleche, die zur Abschirmung elektromagnetischer Strahlung dienen, nachträglich an derartigen Querschienen zu befestigen. Diese Befestigung erfolgt in bekannter Weise dadurch, daß die Wabenbleche von einem U-förmigen Rahmen aufgenommen werden, der seinerseits an seiner Außenseite mit einer metallischen Dichtschnur versehen ist. Dieser Rahmen wird in bekannter Weise durch besondere Befestigungsmittel mit den mit den Seitenwänden verbundenen Querschienen befestigt. Dabei liegt das Wabenblech mehr oder weniger locker innerhalb der U-förmigen Nut, während die elektromagnetische Dichtung zwischen dem Rahmen und den Querprofilschienen mittels der ein Übermaß aufweisenden, schnurförmigen Dichtung erfolgt, die beim Verschrauben des Rahmens mit den Querprofilschienen zusammengepreßt wird. Diese Bauart erfordert einen hohen Material- und Arbeitsaufwand.

Zur Verbesserung der Dichtwirkung zwischen einem derartigen U-förmigen Rahmen und dem von dem Rahmen aufgenommenen Wabenblech ist ferner bekannt, den Rahmen durch zwei winkelförmige Teile auszubilden, die nach Einlegen des Wabenbleches miteinander verschraubt werden. Auch diese Bauart hat einen hohen Material- und Arbeitsaufwand.

Es ist ferner eine U-förmige Schiene mit einem drehbaren, beweglichen Schenkel bekannt, wobei die einander gegenüberliegenden Schenkel jeweils eine Nase aufweisen. Zur Montage wird dabei das Wabenblech bei geöffnetem Schenkel in die Nut eingeschoben und danach durch Niederdrücken des beweglichen Schenkels in der Nut festgehalten. Dabei graben sich die direkt einander gegenüberliegenden Nasen in das Wabenblech ein. Neben einem hohen Aufwand wegen der beweglichen Anordnung des einen Schenkels ergibt sich hierbei der Nachteil, daß das Wabenblech in den von den Nasen gebildeten Kerben locker gehalten ist und somit eine strahlungssichere Dichtung nicht mehr gewährleistet ist.

Der Erfindung liegt die Aufgabe zugrunde, einen Baugruppenträger der eingangs genannten Art zu schaffen, der mit wenig Aufwand eine zuverlässige strahlungssichere Abdichtung gewährleistet.

Diese Aufgabe wird gemäß der Erfindung bei einem Baugruppenträger der eingangs genannten Art dadurch gelöst, man je zwei Querprofilschienen mit einem Wabenblech und mit zwei Seitenprofilschienen eine strahlungssichere, in sich selbständige, vormontierbare Baueinheit bilden.

Diese Bauseise hat den Vorteil, daß der Bau eines rohen Gerüstes, das beim Stand der Technik aus zwei Seitenwänden und mehreren Quertraversen besteht, nun nicht mehr erforderlich ist. Vielmehr werden die beiden Seitenwände direkt durch mindestens zwei Tableaus miteinander verbunden, die in sich eine abgeschlossene, störstrahlsichere Baueinheit bilden und ihrerseits störstrahlsicher mit den Seitenwandungen verbunden sind. Es ist also nicht mehr erforderlich, zunächst die Seitenwandungen, wie beim Stand der Technik üblich, durch Quertraversen miteinander zu einem Rohgerüst zu verbinden und sodann in einem besonderen Arbeitsgang ein in einem Rahmen gefaßtes Wabenblech zu montieren. Zwei derartige, erfindungsgemäße Tableaus bilden zwischen sich einen Raum zur Aufnahme von einschiebbaren Funktionseinheiten, z.B. Leiterplatten. Dazu können diese Baueinheiten direkt mit Führungsschienen zur Aufnahme derartiger Leiterplatten versehen werden.

Die störstrahlsichere Dichtung der Baueinheiten gegenüber den Seitenwandungen erfolgt in Ausgestaltung der Erfindung vorzugsweise durch federnde, sogenannte EMV-Dichtelemente, die sich bei der Montage der Baueinheiten federnd gegen die Seitenwandungen andrücken und somit eine zuverlässige elektromagnetische Abdichtung bewirken. Der Begriff EMV (elektro-magnetische Verträglichkeit) wird nachfolgend verwendet im Zusammenhang mit Abschirmung gegenüber elektromagnetischen oder elektrostatischen Feldern. So bedeutet der Ausdruck "EMV-dicht", daß eine Abdichtung gegenüber elektromagnetischen oder elektrostatischen Feldern gegeben ist. "EMV-dicht" soll das gleiche aussagen wie "HF-dicht (hochfrequenzdicht).

In Ausgestaltung der Erfindung ist vorgesehen, daß die Seitenwände in den vier Befestigungsbereichen eines Tableaus mit nach innen gerichteten, waagerechten Ausprägungen zur Auflage eines Tableaus, mit nach innen gerichteten senkrechten Ausprägungen zum Eingriff in Senkrechtnuten des Tableaus und mit Bohrungen zur Aufnahme von Befestigungsschrauben für das Tableau versehen sind. Die genannten Ausprägungen und die Bohrungen sind vorzugsweise jeweils im Bereich der stirnseitigen Ecken eines Tableaus angeordnet, um eine möglichst große Stabilität zu erhalten.

Dabei ist in Ausgestaltung der Erfindung vorgesehen, daß die stirnseitigen Enden der Querprofilschienen jeweils mindestens eine rechtwinklig zur Ebene des Tableaus verlaufende, halbkreisförmige Nut zum Eingriff der an den Seitenwandungen angeordneten, nach innen gerichteten senkrechten Ausprägungen aufweisen. Die senkrechte Ausbildung der Ausprägungen und der halbkreisförmigen Nuten verleiht dem eingesetzten Tableau eine zuverlässige Sicherheit gegen Verdrehen.

Eine einfache Verbindung der Seitenwände mit den Tableaus erfolgt vorzugsweise dadurch, daß die Querprofilschienen jeweils einen ersten Längskanal zur Aufnahme von in Längsrichtung einschraubbaren Befestigungsschrauben für die Seitenwandungen aufweisen.

Um zu gewährleisten, daß die als selbständige Baueinheiten ausgebildeten Tableaus auch im eingebauten Zustand gegenüber den Seitenwandungen EMV-dicht abgeschlossen sind, ist in Ausgestaltung der Erfindung vorgesehen, daß die Seitenprofilschienen an ihren den Seitenwandungen zugekehrten Seiten jeweils mit EMV-dichten Federelementen versehen sind. Dadurch ist gewährleistet, daß der Spalt zwischen den Seitenwänden und den Tableaus zuverlässig gegen elektromagnetische Strahlung abgedichtet ist.

In weiterer Ausgestaltung der Erfindung ist vorgesehen, daß die Querprofilschienen von zwei übereinanderliegenden Tableaus jeweils mit Führungsschienen zur Aufnahme von parallel zu den Seitenwandungen einschiebbaren Funktionseinheitenversehen sind. Dazu ist beispielsweise jeweils einer der Schenkel der U-förmigen Querprofilschienen verlängert und mit Bohrungen zum Einknöpfen der Führungsschienen versehen. Diese Bauweise ermöglicht eine einfache Montage der Führungsschienen.

Um z.B. eine Frontblende oder eine Rückwandleiterplatte auf einfache Weise befestigen zu können, weisen die Querprofilschienen in weiterer Ausgestaltung der Erfindung jeweils einen zweiten, zur Stirn- oder Rückseite des Baugruppenträgers hin offenen Längskanal zur Aufnahme von quer zur Längserstreckung des Kanals einsetzbaren Befestigungsschrauben auf.

Die Querprofilschienen können in einer weiteren Ausgestaltung der Erfindung jeweils einen dritten Längskanal zur Aufnahme einer Gewindeschiene aufweisen, an der über Befestigungsschrauben weitere Bauteile auf einfache Weise befestigt werden können.

In weiterer Ausgestaltung der Erfindung ist vorgesehen, daß der von zwei Tableaus begrenzte Raum zur Aufnahme von einschiebbaren Funktionseinheiten bzw. Baugruppen durch eine an der oberen Querprofilschiene einhängbare Frontblende verschließbar ist, die eine umlaufende, federnde EMV-Dichtung aufweist und die unter Zusammendrücken der federnden Dichtung in eine verriegelbare Schließstellung gebracht werden kann. Zum Verschließen der durch die Tableaus gebildeten Öffnung reicht es somit aus, die Frontblende an ihrer oberen Seite einzuhängen und, unter Ausnutzung der Schwerkraft, in die Schließstellung zu bringen. Dabei genügt zur Überwindung der Federkraft ein leichter Druck gegen die Frontblende.

Die obere Querprofilschiene und die Frontblende sind dabei im Einhängbereich vorzugsweise derart profiliert, daß die Frontblende nach dem Einhängen beim Schließvorgang selbst arretiert wird. Damit ist ein Herausnehmen bzw. ein Herausfallen der Tür praktisch nicht mehr möglich.

Vorzugsweise sind die obere und untere Querprofilschiene jeweils mit Kontaktflächen für Kontaktfedern der Frontblende versehen.

Die umlaufende Dichtung der Frontblende besteht vorzugsweise aus federnden Elementen, die in den beiden horizontalen Randbereichen direkt an der Innenseite der Frontblende und in den beiden senkrechten Randbereichen an den Außenseiten von rechtwinklig abgewinkelten Flanschen angebracht sind. Die Dichtwirkung erfolgt dabei in den Horizontalbereichen durch Anlage an entsprechenden Dichtflächen der beiden Querprofilschienen und in den senkrechten Bereichen durch Anlage an den Seitenwandungen des Baugruppenträgers.

Vorzugsweise sind seitliche Verriegelungselemente vorgesehen, durch welche die Frontblende in ihrer Schließstellung verriegelbar ist.

In weiterer Ausgestaltung der Erfindung ist vorgesehen,
- daß die Quer- und Seitenprofilschienen durch Eckverbinder zu einem Rahmen mit einer innenliegenden, umlaufenden, U-förmigen Nut zur Halterung des Wabenbleches versehen sind,
- daß die mit ihren Schenkel gegeneinander gerichteten vorderen und hinteren Querprofilschienen innenseitig jeweils mit in das Wabenblech eingreifenden, gegeneinander versetzt angeordneten Nasen versehen sind und
- daß die Seitenprofilschienen mit mit ihren Nutgründen gegen die aufgeschnittenen Kanten des Wabenbleches gedrückt sind.

Durch die Eckverbinder können die Quer- und Längsprofilschienen schnell und einfach miteinander verbunden werden. Dabei liegt das Wabenblech allseitig in den Nuten der Querprofilschienen einerseits und in den Nuten der Seitenprofilschienen andererseits. Die an den Innenseiten der Nutschenkel der Querprofilschienen vorgesehen Nasen dienen zur Herstellung einer EMV-Dichtung zwischen dem Wabenblech und den Querprofilschienen. Durch die versetzte Anordnung der Nasen wird das Wabenblech, wie weiter unten beschrieben wird, zwischen den Profilschienen verspannt, so daß eine zuverlässige EMV-Dichtung gewährleistet ist. Im Bereich der Seitenprofilschienen dient die Nut in erster Linie zur Führung des Wabenbleches, während die EMV-Dichtung dadurch erzielt wird, daß das federnd eingespannte Wabenblech mit seinen durch Abschneiden gebildeten Kanten der Waben in die jeweilige Nut der Seitenprofilschienen gedrückt ist.

Dabei ist vorgesehen, daß der parallel zu den Schenkeln einer Querprofilschiene gemessene Abstand der einander zugewandten, gegeneinander versetzten Nasen etwas kleiner ist als die Dicke des von den beiden Schenkeln der Querprofilschiene zu umfassenden Wabenbleches. Damit wird sichergestellt, daß bei der Montage die Nasen auf zuverlässige Weise in das Wabenblech eingreifen können.

Eine zweckmäßige Ausgestaltung der Erfindung besteht darin, daß die von den Schenkeln einer Querprofilschiene gebildete Nut zur Aufnahme des Wabenbleches an ihrem Grund zu einem Nutkanal für die Aufnahme der Eckverbinder ausgebildet ist. Damit ergibt sich eine einfache Montage der Eckverbinder zusammen mit dem Wabenblech.

Die Erfindung bezieht sich ferner auf eine Querprofilschiene zur Aufnahme eines Wabenbleches und ist dadurch gekennzeichnet,
a) daß sie eine längsgerichtete, im Querschnitt U-förmige Nut mit zueinander parallel verlaufenden Schenkeln aufweist,
b) daß beide Schenkel je eine nach innen gerichtete, gegeneinander versetzt angeordnete Nase aufweisen und
c) daß der gegenseitige Abstand beider Nasen - gemessen als Abstand der beiden Ebenen, die jeweils das Ende der Nasen enthalten und parallel zu den Schenkeln verlaufen - etwas kleiner ist als die Dicke eines in die Nut einzuführenden Wabenbleches.

Wenn ein Wabenblech in die Nut einer derartigen Querprofilschiene eingeschoben werden soll, so gelingt dies nur, wenn das Wabenblech schräg zu den Schenkelebenen der Querprofilschiene eingeschoben wird, da die Dicke des Wabenbleches größer ist als der gegenseitige Abstand der beiden Nasen. Nach dem Einschieben bis zum Anschlag liegt somit das Wabenblech schräg in der Nut. Diese Tatsache wird ausgenutzt, um das Wabenblech in zwei gegenüberliegenden Querprofilschienen mit derartig ausgebildeten Nuten zu verspannen.

Dies erfolgt gemäß einem Verfahren zur Herstellung eines von Profilschienen eingefaßten Wabenblechs, durch folgende Merkmale:
a) das Wabenblech wird auf zwei gegenüberliegenden Seiten schräg in eine durch die versetzten Nasen gebildete Nutöffnung je einer Querprofilschiene eingeschoben, so daß die Ebenen der Schenkel winklig zur Oberfläche des Wabenbleches verlaufen,
b) die beiden Profilschienen werden unter gleichzeitiger Einkerbung der Nasen in das Wabenblech und unter Verspannung des Wabenbleches so weit gedreht, daß die Schenkelebenen parallel zu den Oberflächen des Wabenbleches verlaufen,
c) die mit rechtwinkligen Eckverbindern versehenen Seitenprofilschienen werden gegen die freien Seiten des scharfkantigen, federnde Wabenbleches gepreßt, wobei die freien Enden der Eckverbinder in Nutkanäle der Querprofilschienen eingreifen und die U-förmigen Seitenprofilschienen sich an die aufgeschnittenen Profile des Wabenbleches EMV-dicht anlegen und das Wabenblech führend umgreifen.

In der Zeichnung sind in den Fig. 1 bis 12 Ausführungsbeispiele des Gegenstandes gemäß der Erfindung schematisch dargestellt.
Fig. 1 zeigt die perspektivische Darstellung eines Baugruppenträgers mit drei eingebauten selbständigen Baueinheiten (Tableaus),
Fig. 2 zeigt eine vergrößerte perspektivische Darstellung des unteren Tableaus,
Fig. 3 zeigt eine vergrößerte Einzelheit Z gemäß Fig. 2,
Fig. 4 und 5 zeigen einen vergrößerten Querschnitt durch zwei Querprofilschienen mit einem eingesetzten Wabenblech in einer Montagephase und in einem fertig montierten Zustand,
Fig. 6 und 7 zeigen in vergrößerter Darstellung die Vorder- und Seitenansicht einer Frontblende,
Fig. 8 und 9 zeigen jeweils in vergrößerter Darstellung Einzelheiten X, Y gemäß Fig. 7,
Fig. 10 zeigt einen Schnitt X-X gemäß Fig. 7,
Fig. 11 zeigt eine Teilansicht des mittleren Tableaus, und
Fig. 12 zeigt eine schematische Seitenansicht der in Fig. 1 verwendeten Profile.

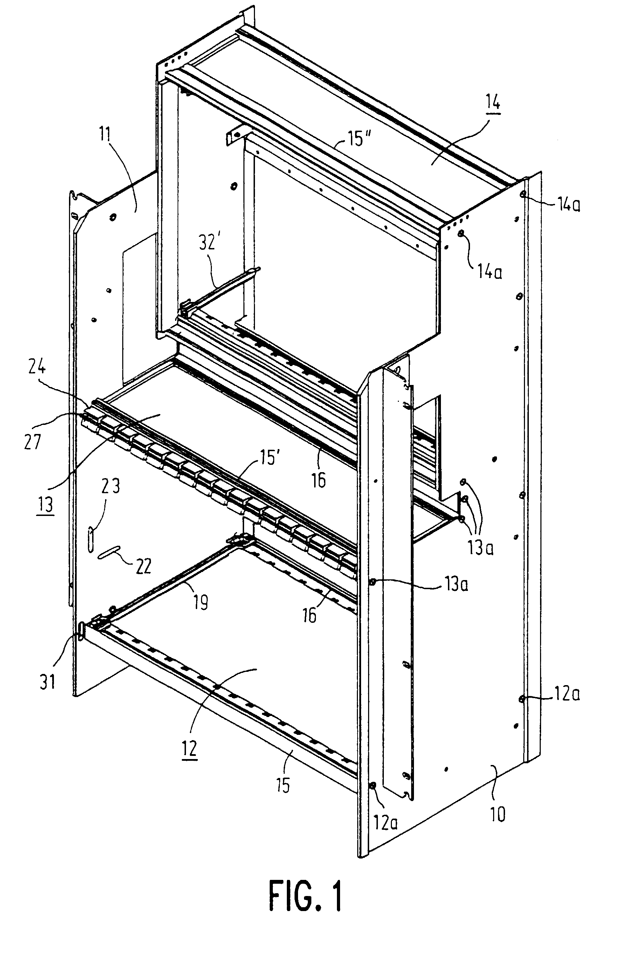

Der Baugruppenträger gemäß Fig. 1 besitzt zwei Seitenwände 10 und 11, die durch drei als selbständige Baueinheiten ausgebildete Tableaus 12, 13 und 14 verbunden sind. Zur Befestigung der Tableaus 12 bis 14 an den Seitenwänden 10 und 11 dienen Schrauben 12a, 13a, 14a.

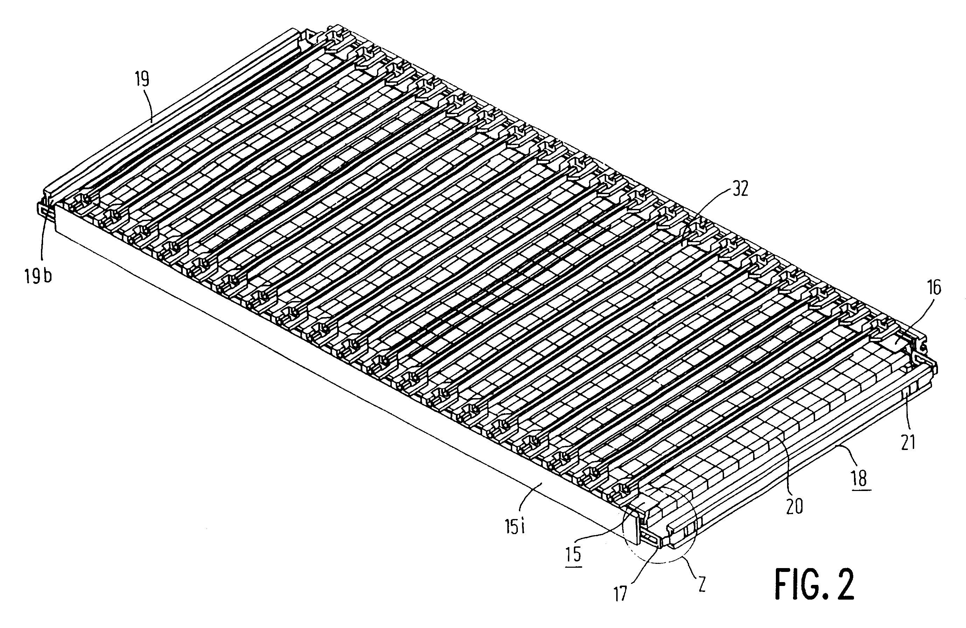

Jedes Tableau ist aus gleichen Grundbausteinen aufgebaut, und zuwar aus zwei Querprofilschienen, zwei Seitenprofilschienen, vier Eckverbindern und einem Wabenblech. Fig. 2 zeigt das untere Tableau 12 mit zwei Querprofilschienen 15, 16, die über Eckverbinder 17 mit Seitenprofilschienen 18, 19 zu einem Rahmen zusammengesteckt sind, der zur Aufnahme und Halterung eines Wabenbleches 20 ausgebildet ist. Das Wabenblech 20 dient zur Abschirmung elektromagnetischer Felder und gewährt gleichzeitig eine gute Durchlüftung. Die Eckverbinder 17 sind einerseits in Nuten 18a der Seitenprofilschienen und andererseits in Nuten 15a bzw. 16a der Querprofilschienen eingesteckt. In die Nuten 18a sind außerdem noch metallische Federelemente 21 eingesetzt, die im eingebauten Zustand der Tableaus 12 bis 14 an die Seitenwände 10, 11 angedrückt werden und somit eine zuverlässige EMV-Dichtung gewährleisten.

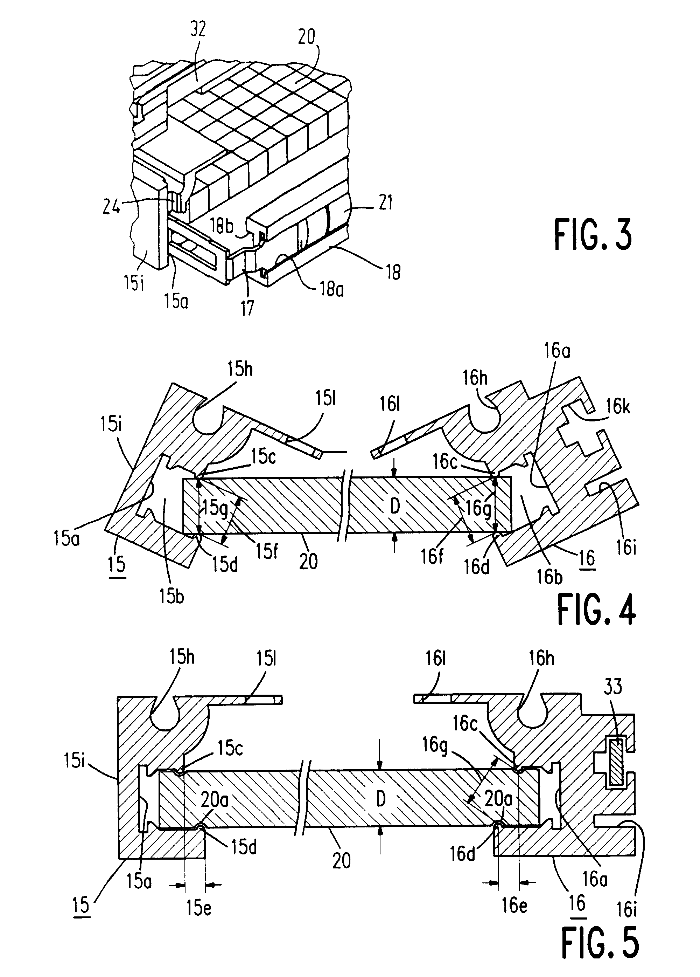

Der Aufbau der Querprofilschienen 15, 16 ist aus den Fig. 4 und 5 erkennbar. Dabei zeigt jeweils der linke Teil der Fig. 4 und 5 die vordere Querprofilschiene 15 und der rechte Teil die hintere Querprofilschiene 16. Mit 15a, 16a sind die oben bereits erwähnten Längskanäle zur Aufnahme der Eckverbinder 17 bezeichnet. Die Querprofilschienen 15, 16 besitzen innenseitig liegende U-förmige Nuten 15b, 16b, deren Schenkel jeweils mit gegeneinander gerichteten Nasen 15c, d, 16c, d versehen sind. Diese Nasen sind jeweils gegeneinander um das Maß 15e, 16e versetzt und haben einen gegenseitigen Abstand 15f, 16f. Die Verbindungslinie beider Nasen 15c, d, 16c, d bildet eine vergrößerte Einführöffnung 15g, 16g zur Einführung des Wabenbleches 20.

Die Montage des Wabenbleches 20 erfolgt gemäß Fig. 4 und 5 derart, daß zunächst die Querprofilschienen 15, 16 über die Einführöffnungen 15g, 16g schräg auf zwei gegenüberliegende Kanten des Wabenbleches 20 geschoben werden. Danach werden die Querprofilschienen 15, 16 so weit gedreht, daß ihre Schenkeloberflächen parallel zu den Oberflächen des Wabenbleches 20 verlaufen, wie in Fig. 5 dargestellt. Dabei graben sich die Nasen 15c, d, 16c, d unter Bildung von Kerben 20a in das Wabenblech ein, und das Wabenblech verspannt sich. In diesem Zustand werden die Seitenprofilschienen 18, 19 aufgeschoben, so daß das Wabenblech 20 von den Innennuten 18b, 19b der Seitenprofilschienen umfaßt und geführt wird. Gleichzeitig werden dabei die Eckverbinder 17 in die Längskanäle 15a, 16a eingeführt. Nach Abschluß dieser Arbeiten ergibt sich ein in sich stabiles, EMV-dichtes Tableau, das als selbständige Baueinheit zwischen den Seitenwänden 10, 11 gemäß Fig. 1 montiert werden kann.

Die Seitenwände 10, 11 sind im Eckbereich der zu montierenden Tableaus 12 bis 14 jeweils mit nach innen gerichteten waagerechten Ausprägungen 22 zur Auflage der Tableaus 12 bis 14 und mit senkrechten Ausprägungen 23 versehen, die in entsprechend geformte senkrechte Nuten 24 an den Stirnseiten der Querprofilschienen angebracht sind. Zur Verbindung der Tableaus 12 bis 14 mit den Seitenwandungen 10, 11 dienen Schrauben 12a, 13a, 14a, die jeweils in Längskanäle 15h, 16h der Querprofilschienen 15, 16 eingeschraubt werden können.

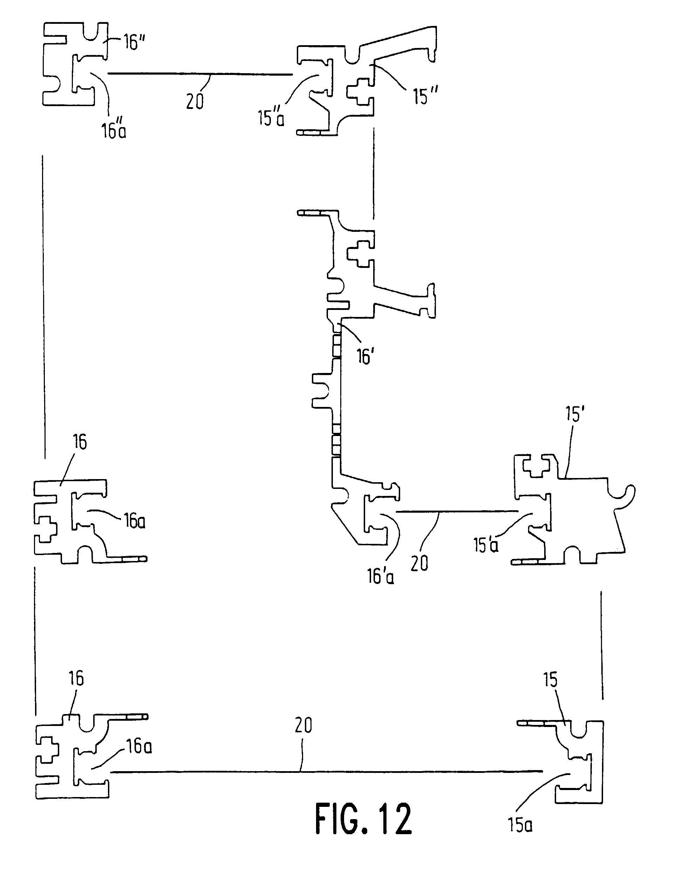

Die vorderen und hinteren Querprofilschienen der Tableaus 12, 13, 14 haben in den Bereichen, in welchen das Wabenblech 20 umfaßt wird, alle das gleiche Profil mit der U-förmigen Nut und den gegeneinander gerichteten Nasen. In ihren Außenbereichen können die Profile jedoch, je nach den Bedürfnissen, unterschiedlich gestaltet sein (siehe Fig. 12). So haben z.B. in Fig. 1 die hinteren Querprofilschienen der Tableaus 12 und 13 die im rechten Teil der Fig. 4, 5 erkennbare Form (Profilschiene 16) Diese Profilschienen bilden Längskanäle 16i zur Aufnahme von Befestigungsschrauben für eine Rückwandleiterplatte und Längskanäle 16k zur Aufnahme einer Gewindeschiene 33.

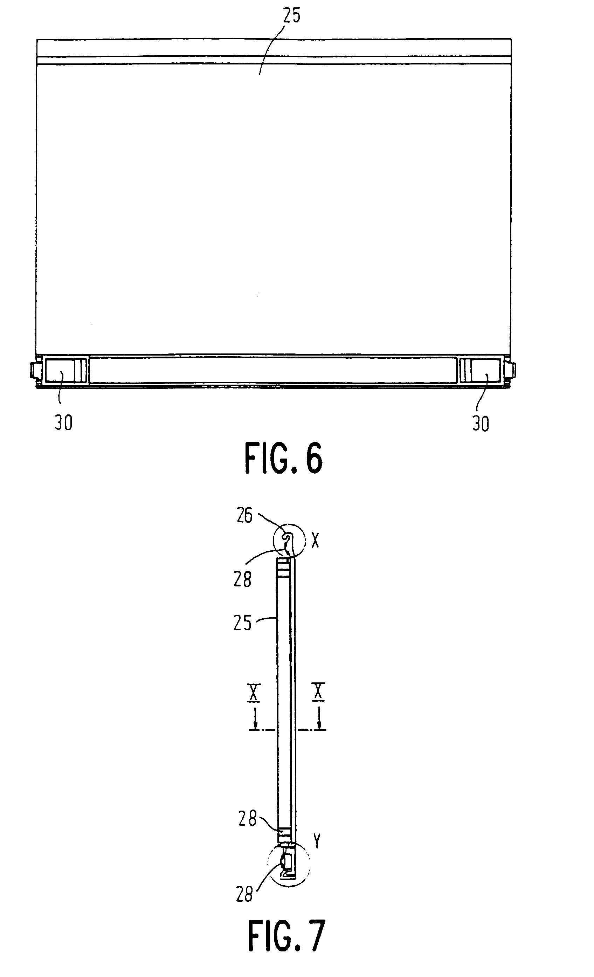

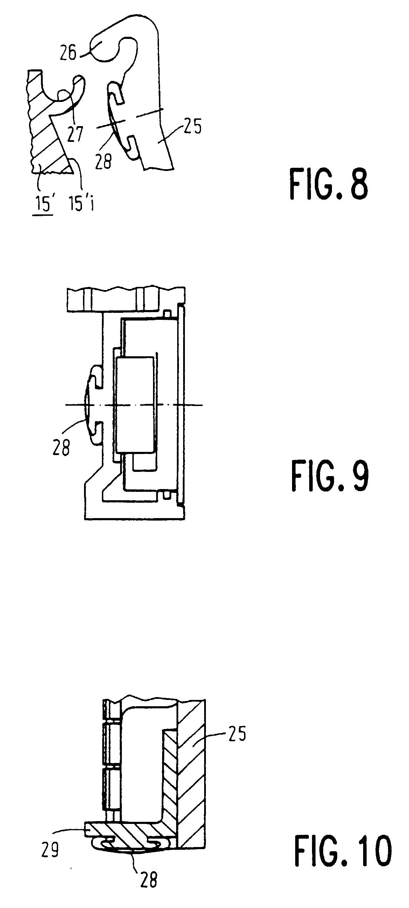

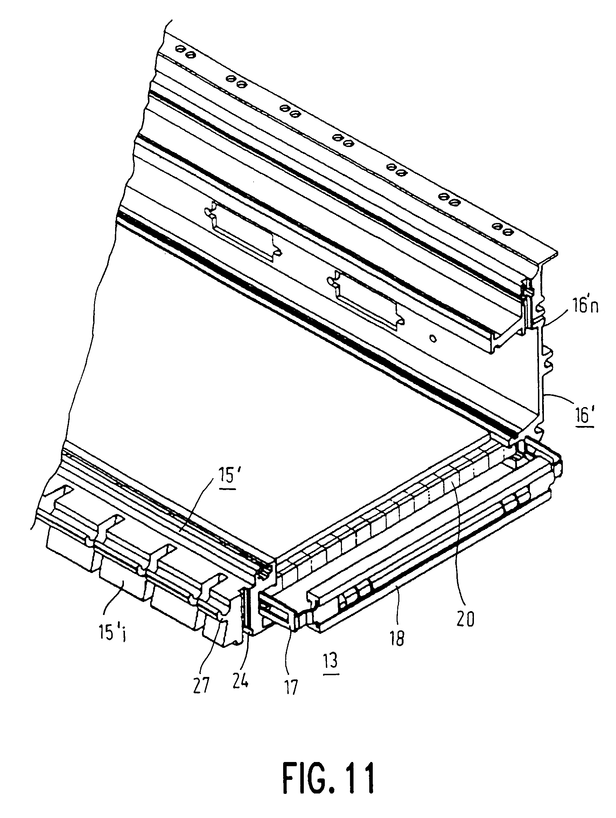

Dagegen sind die vorderen Querprofilschienen der drei Tableaus 12 bis 14 jeweils unterschiedlich ausgebildet. Die Tableaus 12 und 13 bilden einen Raum, der im vorliegenden Ausführungsbeispiel durch eine in Fig. 6, 7 dargestellte Frontblende 25 verschlossen werden kann. Diese Frontblende 25 ist so ausgebildet, daß sie mit ihrer oberen Kante an der entsprechend ausgebildeten vorderen Querprofilschiene 15' des mittleren Tableaus 13 eingehängt werden kann. Dazu besitzt die Frontblende 25 an ihrer Oberkante ein aus Fig. 7 und 8 näher erkennbares, S-förmiges Profil 26, welches mit einem entsprechend ausgebildeten Gegenprofil mit einer rinnenförmigen Ausnehmung 27 an der Querprofilschiene 15' korrespondiert (siehe auch Fig. 11) . Zur Montage wird die Frontblende 25 einfach in die Rinne 27 eingehängt und arretiert sich beim Schließen selbst. Zur HF-Abschirmung besitzt die Frontblende 25 eine umlaufende, aus Einzelelementen bestehende metallische EMV-Dichtung 28, die an den beiden horizontalen Bereichen der Frontblende 25 direkt an der Innenseite angebracht ist. Die Dichtung 28 liegt hier im oberen Bereich an der Dichtungsfläche 15'i der Querprofilschiene 15' und im unteren Bereich an der Dichtungsfläche 15i der unteren Querprofilschiene 15 an. An den beiden senkrechten Seitenteilen der Frontblende 25 sind abgewinkelte Flansche 29 vorgesehen, die an ihrer Außenseite die Dichtung 28 tragen. In diesen Bereichen liegt die Dichtung 28 im geschlossenen Zustand an den beiden Seitenwänden 10, 11 an. Am unteren Ende der Frontblende 25 sind zwei Riegelelemente 30 angeordnet, die beim Schließen der Frontblende in entsprechende Aussparungen 31 der Seitenwände 10, 11 eingreifen. Zum Schließen wird die Frontblende einfach eingehängt und fällt dann durch Eigengewicht, gegebenenfalls mit leichtem Druck, in ihre Schließstellung, wobei die Reibung der Dichtungen 28 überwunden wird.

In Fig. 2 sind mit 32 Führungsschienen bezeichnet, die jeweils an den vorderen und hinteren Querprofilschienen 15, 16 befestigt sind und zur Aufnahme von nicht dargestellten Baugruppen bzw. Leiterplatten dienen. Diese Baugruppen sind mit elektronischen Bauelementen bestückt und werden von vorn in den Baugruppenträger, z.B. zwischen den beiden Tableaus 12, 13, eingeschoben.

Die Seitenprofilschienen 18, 19 sind für alle Tableaus gleich ausgebildet, unterscheiden sich jeweils nur in der Länge. Das in Fig. 11 teilweise dargestellte mittlere Tableau 13 besitzt an seiner Vorderseite die Querprofilschiene 15' mit den hakenförmigen Aufnahmen 27 zum Einhängen der Frontblende 25 und an seiner Rückseite eine besonders gestaltete Querprofilschiene 16', die jedoch im unteren Bereich ebenfalls wieder die oben beschriebene U-förmige Nut zur Aufnahme des Wabenbleches 20 besitzt, die für alle Querprofilschienen gleich ausgebildet ist. Die Querprofilschiene 16' hat einen nach oben gerichteten längeren Flansch 16'n, der ebenfalls eine Möglichkeit zum Einknöpfen von Führungsschienen 32' aufweist, wie aus Fig. 1 zu erkennen ist.

In Fig. 12 ist schematisch eine Seitenansicht der in Fig. 1 verwendeten verschiedenartigen Profile 15, 15', 15'', 16, 16', 16'' dargestellt, wobei erkennbar ist, daß alle Profile jeweils in dem Bereich 15a, 15'a, 15''a, 16a, 16'a, 16''a , in dem ein Wabenblech 20 gefaßt wird, einen gleich ausgebildeten nutförmigen Bereich mit den vorstehenden, gegeneinander versetzten Nasen aufweisen.

## Patentansprüche

1. Baugruppenträger mit zwei Seitenwänden (10, 11) und mit zwischen den Seitenwänden angeordneten, mit Querprofilschienen (15, 16) verbundenen Wabenblechen (20), dadurch gekennzeichnet, daß je zwei Querprofilschienen (15, 16) mit einem Wabenblech (20) und mit zwei Seitenprofilschienen (18, 19) eine gegenüber elektromagnetischen oder elektrostatischen Feldern abdichtende, in sich selbständige, vormontierbare Baueinheit (12, 13, 14) bilden.

2. Baugruppenträger nach Anspruch 1, dadurch gekennzeichnet, daß der Baugruppenträger mindestens zwei derartige Baueinheiten (12, 13) aufweist, die gegenüber elektromagnetischen oder elektrostatischen Feldern abdichtend durch Befestigungselemente (12a, 13a) mit den Seitenwänden (10, 11) verbunden sind.

3. Baugruppenträger nach Anspruch 1 oder 2, dadurch gekennzeichnet, daß die Seitenwände (10, 11) in den vier Befestigungsbereichen eines Tableaus (12, 13, 14) mit nach innen gerichteten, waagerechten Ausprägungen (22) zur Auflage eines Tableaus (12, 13, 14), mit nach innen gerichteten senkrechten Ausprägungen (23) zum Eingriff in Senkrechtnuten (24) des Tableaus (12, 13, 14) und mit Bohrungen zur Aufnahme von Befestigungsschrauben (12a, 13a, 14a) für das Tableau (12, 13, 14) versehen sind.

4. Baugruppenträger nach Anspruch 3, dadurch gekennzeichnet, daß die stirnseitigen Enden der Querprofilschienen (15, 16) jeweils mindestens eine rechtwinklig zur Ebene des Tableaus (12, 13, 14) verlaufende Nut (24) zum Eingriff der an den Seitenwandungen (10, 11) angeordneten, nach innen gerichteten senkrechten Ausprägungen (23) aufweisen.

5. Baugruppenträger nach einem der Ansprüche 1 bis 4, dadurch gekennzeichnet, daß die Querprofilschienen (15, 16) jeweils einen ersten Längskanal (15h, 16h) zur Aufnahme von in Längsrichtung einschraubbaren Befestigungsschrauben (12a, 13a, 14a) für die Seitenwandungen (10, 11) aufweisen.

6. Baugruppenträger nach einem der Ansprüche 1 bis 5, dadurch gekennzeichnet, daß die Seitenprofilschienen (18, 19) an ihren den Seitenwänden (10, 11) zugekehrten Seiten jeweils mit gegenüber elektromagnetischen oder elektrostatischen Feldern abdichtenden Federelementen (21) versehen sind.

7. Baugruppenträger nach einem der Ansprüche 1 bis 6, dadurch gekennzeichnet, daß die Querprofilschienen (15, 15', 16) von zwei übereinanderliegenden Tableaus (12, 13) an ihren einander zugekehrten Seiten jeweils mit Führungssschienen (32) zur Aufnahme von parallel zu den Seitenwänden (10, 11) einschiebbaren Funktionseinheiten (Leiterplatten) versehen sind.

8. Baugruppenträger nach Anspruch 7, dadurch gekennzeichnet, daß jeweils einer der Schenkel der U-förmigen Querprofilschienen (15, 16) verlängert und mit Bohrungen (151) zum Einknöpfen der Führungsschienen (32) versehen ist.

9. Baugruppenträger nach einem der Ansprüche 1 bis 8, dadurch gekennzeichnet, daß die Querprofilschienen (16) jeweils einen zweiten und/oder dritten, zur Stirn- oder Rückseite des Baugruppenträgers offenen Längskanal (16i, 16k) zur Aufnahme von quer zur Längserstreckung des Kanals einsetzbaren Befestigungsschrauben und/oder zur Aufnahmne einer Gewindeschiene (33) aufweisen.

10. Baugruppenträger nach einem der Ansprüche 1 bis 9, dadurch gekennzeichnet, daß der von zwei Tableaus (12, 13) begrenzte Raum durch eine an der oberen Querprofilschiene (15') einhängbare Frontblende (25) verschließbar ist, die eine umlaufende, federnde EMV-Dichtung (28) aufweist und unter Zusammendrückung der Dichtung (28) in eine verriegelbare Schließstellung gebracht werden kann.

11. Baugruppenträger nach Anspruch 10, dadurch gekennzeichnet, daß die obere Querprofilschiene (15') und die Frontblende (25) im Einhängbereich derart profiliert (26, 27) sind, daß die Frontblende (25) nach dem Einhängen beim Schließvorgang selbst arretiert wird.

12. Baugruppenträger nach einem der Ansprüche 10 oder 11, dadurch gekennzeichnet, daß die obere und untere Querprofilschiene (15', 15) jeweils mit Kontaktflächen (15'i, 15i) für die Kontaktfedern (28) versehen sind.

13. Baugruppenträger nach Anspruch 10, 11 oder 12, dadurch gekennzeichnet, daß die umlaufende Dichtung (28) aus federnden Elementen besteht, die in den beiden horizontalen Randbereichen direkt an der Innenwand der Frontblende (25) und in den beiden senkrechten Randbereichen an den Außenseiten von rechtwinklig abgewinkelten Flanschen (29) angebracht sind.

14. Baugruppenträger nach einem der Ansprüche 11 bis 13, gekennzeichnet durch seitliche Verriegelungselemente (30, 31), durch welche die Frontblende (25) in ihrer Schließstellung verriegelbar ist.

15. Baugruppenträger nach einem der Ansprüche 1 bis 14, dadurch gekennzeichnet,
- daß die Quer- und Seitenprofilschienen (15, 16, 18, 19) durch Eckverbinder (17) zu einem Rahmen mit einer innenliegenden, umlaufenden, U-förmigen Nut zur Aufnahme und Halterung des Wabenbleches (20) versehen sind,
- daß die mit ihren Schenkeln gegeneinander gerichteten vorderen und hinteren Querprofilschienen (15, 16) innenseitig jeweils mit in das Wabenblech (20) eingreifenden, gegeneinander versetzt angeordneten Nasen (15c, d, 16c, d) versehen sind und
- daß die Seitenprofilschienen (18, 19) mit Nuten (18b, 19b) unter Federdruck gegen die aufgeschnittenen Kanten des Wabenbleches (20) gedrückt sind.

16. Baugruppenträger nach Anspruch 15, dadurch gekennzeichnet, daß der parallel zu den Schenkeln einer Querprofilschiene (15, 16) gemessene Abstand (15f, 16f) der einander zugewandten, gegeneinander versetzten Nasen (15c, d, 16c, d) etwas kleiner ist als die Dicke (D) des von den beiden Schenkeln zu umfassenden Wabenbleches (20).

17. Baugruppenträger nach Anspruch 15 oder 16, dadurch gekennzeichnet, daß die von den Schenkeln einer Querprofilschiene (15, 16) gebildete Nut (15b, 16b) zur Aufnahme des Wabenbleches (20) an ihrem Grund zu einem längsgerichteten Nutkanal (15a, 16a) für die Aufnahme der Eckverbinder (17) ausgebildet ist.

18. Querprofilschiene zur Halterung eines Wabenbleches (20) nach einem der Ansprüche 15 bis 17, dadurch gekennzeichnet, daß
a) daß sie eine längsgerichtete, im Querschnitt U-förmige Nut (15b) mit zueinander parallel verlaufenden Schenkeln aufweist,
b) daß beide Schenkel je eine nach innen gerichtete, gegeneinander versetzt angeordnete Nase (15c, d) aufweisen und
c) daß der gegenseitige Abstand beider Nasen (15c, d) - gemessen als Abstand (15f) der beiden Ebenen, die jeweils das Ende der Nasen (15c, d) enthalten und parallel zu den Schenkeln verlaufen - etwas kleiner ist as die Dicke (D) des in die Nut (15b) einzuführenden Wabenbleches (20)

19. Verfahren zur Herstellung eines von Profilschienen eingefaßten Wabenblechs (20) , nach einem der Ansprüche 1 bis 18, gekennzeichnet durch folgende Merkmale:
a) das Wabenblech (20) wird auf zwei gegenüberliegenden Seiten schräg in eine durch die versetzten Nasen (15c, d, 16c, d) gebildete Nutöffnung (15g, 16g) je einer Querprofilschiene (15, 16) eingeschoben, so daß die Ebenen der Schenkel winklig zur Oberfläche des Wabenbleches (20) verlaufen (Fig. 4),
b) die beiden Querprofilschienen (15, 16) werden unter gleichzeitiger Einkerbung (20a) der Nasen (15c, d, 16c, d) in das Wabenblech und unter Verspannung des Wabenbleches (20) so weit gedreht, daß die Schenkelebenen parallel zu den Oberflächen des Wabenbleches (20) verlaufen (Fig. 5),
c) die mit rechtwinkligen Eckverbindern (17) versehenen Seitenprofilschienen (18, 19) werden gegen die freien Seiten des scharfkantigen, federnden Wabenbleches (20) gepreßt, wobei die freien Enden der Eckverbinder (17) in Nutkanäle (15a, 16a) der Querprofilschienen (15, 16) eingreifen und die U-förmigen Seitenprofilschienen (18, 19) sich an die aufgeschnittenen Profile des Wabenbleches (20) gegenüber elektromagnetischen oder elektrostatischen Feldern abdichtend anlegen und das Wabenblech führend umgreifen.

## Claims

1. Mounting rack having two side walls (10, 11) and having honeycomb plates (20) which are arranged between the side walls and are connected to transverse profiled rails (15, 16), characterized in that two transverse profiled rails (15, 16) in each case together with one honeycomb plate (20) and two side profiled rails (18, 19) form a unit which provides screening against electromagnetic or electrostatic fields, is intrinsically autonomous and can be preassembled (frames 12, 13, 14).

2. Mounting rack according to Claim 1, characterized in that the mounting rack has at least two such units (12, 13) which are connected to the side walls (10, 11) by means of attachment elements (12a, 13a) such that they are screened against electromagnetic or electrostatic fields.

3. Mounting rack according to Claim 1 or 2, characterized in that the side walls (10, 11) are provided in the four attachment regions of a frame (12, 13, 14) with horizontal projections (22), which point inwards, for mounting of a frame (12, 13, 14), with vertical projections (23), which point inwards, for engaging in vertical grooves (24) in the frame (12, 13, 14) and with holes for accommodating attachment screws (12a, 13a, 14a) for the frame (12, 13, 14).

4. Mounting rack according to Claim 3, characterized in that the end-face ends of the transverse profiled rails (15, 16) each have at least one groove (24), which runs at right angles to the plane of the frame (12, 13, 14), for engagement of the vertical projections (23), which are arranged on the side walls (10, 11) and point inwards.

5. Mounting rack according to one of Claims 1 to 4, characterized in that the transverse profile rails (15, 16) each have a first longitudinal channel (15h, 16h) for accommodating attachment screws (12a, 13a, 14a), which can be screwed in in the longitudinal direction, for the side walls (10, 11).

6. Mounting rack according to one of Claims 1 to 5, characterized in that the side profiled rails (18, 19) are each provided on their sides facing the side walls (10, 11) with spring elements (21) which provide screening against electromagnetic or electrostatic fields.

7. Mounting rack according to one of Claims 1 to 6, characterized in that the transverse profiled rails (15, 15', 16) of two frames (12, 13) which are located one above the other are each provided on their mutually facing sides with guide rails (32) for accommodating functional units (printed circuit boards) which can be pushed in parallel to the side walls (10, 11).

8. Mounting rack according to Claim 7, characterized in that one of the limbs of the U-shaped transverse profiled rails (15, 16) is in each case lengthened and is provided with holes (151) for the guide rails (32) to be clipped into.

9. Mounting rack according to one of Claims 1 to 8, characterized in that the transverse profiled rails (16) each have a second and/or third longitudinal channel (16i, 16k), which is open towards the end face or rear face of the mounting rack, for accommodating attachment screws, which can be inserted transversely with respect to the longitudinal extent of the channel, and/or for accommodating a threaded rail (33).

10. Mounting rack according to one of Claims 1 to 9, characterized in that the space which is bounded by two frames (12, 13) can be closed by a front panel (25) which can be suspended on the upper transverse profiled rail (15'), has a circumferential, resilient EMC screen (28) and, with the screen (28) being compressed, can be moved to a lockable, closed position.

11. Mounting rack according to Claim 10, characterized in that the upper transverse profiled rail (15') and the front panel (25) are profiled (26, 27) in the suspension region in such a manner that the front panel (25) is automatically locked during the closing process after being hooked in.

12. Mounting rack according to one of Claims 10 or 11, characterized in that the upper and the lower transverse profiled rail (15', 15) are respectively provided with contact surfaces (15'i, 15i) for the contact springs (28).

13. Mounting rack according to Claim 10, 11 or 12, characterized in that the circumferential screen (28) is composed of resilient elements which are fitted, in the two horizontal edge regions, directly on the inner wall of the front panel (25) and, in the two vertical edge regions of the outsides of flanges (29) which are bent out at right angles.

14. Mounting rack according to one of Claims 11 to 13, characterized by side locking elements (30, 31) by means of which the front panel (25) can be locked in its closed position.

15. Mounting rack according to one of Claims 1 to 14, characterized
- in that the transverse and the side profiled rails (15, 16, 18, 19) are provided with corner connectors (17) to form a framework having an internal, circumferential, U-shaped groove for accommodating and holding the honeycomb plate (20),
- in that the front and rear transverse profiled rails (15, 16), whose limbs point towards one another, are each provided on the inside with tabs (15c, d, 16c, d) which engage in the honeycomb plate (20) and are offset with respect to one another, and
- in that the side profiled rails (18, 19) are pressed, subject to spring pressure, by means of grooves (18b, 19b) against the cut edges of the honeycomb plate (20).

16. Mounting rack according to Claim 15, characterized in that the distance (15f, 16f), measured parallel to the limbs of a transverse profiled rail (15, 16), between mutually facing, mutually offset tabs (15c, d, 16c, d) is somewhat less than the thickness (D) of the honeycomb plate (20) which is to be surrounded by the two limbs.

17. Mounting rack according to Claim 15 or 16, characterized in that the groove (15b, 16b) which is formed by the limbs of a transverse profiled rail (15, 16) is designed to accommodate the honeycomb plate (20) at its base, in order to form a longitudinally pointing grooved channel (15a, 16a) for accommodating the corner connectors (17).

18. Transverse profiled rail for holding a honeycomb plate (20) according to one of Claims 15 to 17, characterized
a) in that said transverse profiled rail has a longitudinally pointing groove (15b) with a U-shaped cross-section and limbs which run parallel to one another,
b) in that the two limbs each have a tab (15c, d), which tabs point inwards and are arranged offset with respect to one another, and
c) in that the distance between the two tabs (15c, d) - measured as the distance (15f) between the two planes which respectively contain the ends of the tabs (15c, d) and run parallel to the limbs - is somewhat less than the thickness (D) of the honeycomb plate (20) which can be inserted into the groove (15b).

19. Method for manufacturing a frame which is composed of a honeycomb plate (20) gripped by profiled rails as claimed in one of Claims 1 to 18, characterized by the following features:
a) the honeycomb plate (20) is pushed, on two opposite sides, obliquely into a groove opening (15g, 16g) of in each case one transverse profiled rail (15, 16), this groove opening (15g, 16g) being formed by the offset tabs (15c, d, 16c, d) such that the planes of the limbs run at an angle to the surface of the honeycomb plate (20) (Fig. 4),
b) the two transverse profiled rails (15, 16) are rotated, with the tabs (15c, d, 16c, d) at the same time being rotated in the notches (20a) in the honeycomb plate and with the honeycomb plate (20) being brazed, until the limb planes run parallel to the surfaces of the honeycomb plate (20) (Fig. 5),
c) the side profiled rails (18, 19), which are provided with rectangular corner connectors (17), are pressed against the free sides of the sharp-edged resilient honeycomb plate (20), in the process of which the free ends of the corner connectors (17) engage in groove channels (15a, 16a) in the transverse profiled rails (15, 16), and the U-shaped side profiled rails (18, 19) rest against the cut profiles of the honeycomb plate (20), providing screening against electromagnetic or electrostatic fields, and engage around the honeycomb plate so as to guide it.

## Revendications

1. Rack électronique comprenant deux parois latérales (10, 11) et des tôles en nid d'abeilles (20) situées entre les parois latérales, reliées à des rails profilés transversaux (15, 16), caractérisé en ce que deux rails profilés transversaux (15, 16) forment à chaque fois, avec une tôle en nid d'abeilles (20) et avec deux rails profilés latéraux (18, 19), une unité modulaire prémontable autonome, isolant des champs électromagnétiques ou électrostatiques (tableau 12, 13, 14).

2. Rack électronique selon la revendication 1, caractérisé en ce que le rack électronique présente au moins deux unités modulaires de ce type (12, 13), qui sont connectées, de manière isolant des champs électromagnétiques ou électrostatiques, par des éléments de fixation (12a, 13a), aux parois latérales (10, 11).

3. Rack électronique selon la revendication 1 ou 2, caractérisé en ce que les parois latérales (10, 11) sont pourvues, dans les quatre zones de fixation d'un tableau (12, 13, 14) de déformations horizontales (22) orientées vers l'intérieur, pour l'appui d'un tableau (12, 13, 14), de déformations verticales (23) orientées vers l'intérieur, pour venir en prise dans des rainures verticales (24) du tableau (12, 13, 14) et d'alésages pour recevoir des vis de fixation (12a, 13a, 14a) pour le tableau (12, 13, 14).

4. Rack électronique selon la revendication 3, caractérisé en ce que les extrémités frontales des rails profilés transversaux (15, 16) présentent chacune au moins une rainure (24) s'étendant à angle droit par rapport au plan du tableau (12, 13, 14), pour venir en prise avec les déformations (23) verticales orientées vers l'intérieur, disposées dans les parois latérales (10, 11).

5. Rack électronique selon l'une quelconque des revendications 1 à 4, caractérisé en ce que les rails profilés transversaux (15, 16) présentent chacun un premier canal longitudinal (15h, 16h) pour recevoir des vis de fixation (12a, 13a, 14a) pour les parois latérales (10, 11), vissables dans le sens longitudinal.

6. Rack électronique selon l'une quelconque des revendications 1 à 5, caractérisé en ce que les rails profilés latéraux (18, 19) sont chacun pourvus, sur leurs côtés tournés vers les parois latérales (10, 11), d'éléments élastiques (21) isolant des champs électromagnétiques ou électrostatiques.

7. Rack électronique selon l'une quelconque des revendications 1 à 6, caractérisé en ce que les rails profilés transversaux (15, 15', 16) de deux tableaux superposés (12, 13), sont pourvus, sur leurs côtés tournés l'un vers l'autre, chacun de rails de guidage (32) pour recevoir des unités fonctionnelles (cartes de circuits imprimés) insérables parallèlement aux parois latérales (10, 11).

8. Rack électronique selon la revendication 7, caractérisé en ce qu' à chaque fois l'une des branches des rails profilés transversaux en forme de U (15, 16) se prolonge et est pourvue d'alésages (151) pour encliqueter les rails de guidage (32).

9. Rack électronique selon l'une quelconque des revendications 1 à 8, caractérisé en ce que les rails profilés transversaux (16) présentent chacun un deuxième et/ou troisième canal longitudinal (16i, 16k) ouvert sur le côté frontal ou arrière du rack électronique, pour recevoir des vis de fixation insérables transversalement à l'extension longitudinale du canal et/ou pour recevoir une tige filetée (33).

10. Rack électronique selon l'une quelconque des revendications 1 à 9, caractérisé en ce que l'espace limité par deux tableaux (12, 13) peut être fermé par un écran avant (25) pouvant être suspendu au rail profilé transversal supérieur (15'), lequel présente un joint à compatibilité électromagnétique (28) élastique périphérique, et peut être monté dans une position de fermeture verrouillable par pression conjointe du joint (28).

11. Rack électronique selon la revendication 10, caractérisé en ce que le rail profilé transversal supérieur (15') et l'écran avant (25) sont profilés (26, 27) de telle sorte dans la zone de suspension que l'écran avant (25) s'enclenche après la suspension au cours du processus de fermeture.

12. Rack électronique selon l'une quelconque des revendications 10 ou 11, caractérisé en ce que les rails profilés transversaux supérieur et inférieur (15', 15) sont pourvus chacun de surfaces de contact (15'i, 15i) pour les ressorts de contact (28).

13. Rack électronique selon la revendication 10, 11 ou 12, caractérisé en ce que le joint périphérique (28) se compose d'éléments à ressort, qui sont montés directement dans les deux zones de bord horizontales contre la paroi interne de l'écran avant (25) et dans les deux zones de bord perpendiculaires contre les côtés externes de brides (29) tournées à angle droit.

14. Rack électronique selon l'une quelconque des revendications 11 à 13, caractérisé par des éléments de verrouillage latéraux (30, 31) au moyen desquels l'écran avant (25) peut être verrouillé dans sa position de fermeture.

15. Rack électronique selon l'une quelconque des revendications 1 à 14, caractérisé en ce que,
- les rails profilés transversaux et latéral (15, 16, 18, 19) sont prévus pour former, par le biais de fixations d'angle (17), un cadre pourvu d'une rainure en forme de U périphérique, se trouvant à l'intérieur, pour recevoir et fixer la tôle en nid d'abeilles (20),
- en ce que les rails profilés transversaux (15, 16) avant et arrière orientés avec leurs branches opposées sont pourvus du côté interne respectivement de tenons (15c, d, 16c, d) décalés et venant en prise avec la tôle en nid d'abeilles, et
- en ce que les rails profilés latéraux (18, 19) sont pressés avec des rainures (18b, 19b) sous la pression du ressort contre les arêtes ouvertes par coupure de la tôle en nid d'abeilles (20).

16. Rack électronique selon la revendication 15, caractérisé en ce que l'écart (15f, 16f) mesuré parallèlement aux branches d'un rail profilé transversal (15, 16) des tenons décalés tournés l'un vers l'autre (15c, d, 16c, d) est un peu plus petit que l'épaisseur (D) de la tôle en nid d'abeilles (20) devant être entourée par les deux branches.

17. Rack électronique selon la revendication 15 ou 16, caractérisé en ce que la rainure (15b, 16b) formée par les branches d'un rail profilé transversal (15, 16) est formée pour recevoir la tôle en nid d'abeilles (20) sur sa base, pour former un canal de rainure (15a, 16a) orienté longitudinalement pour recevoir les fixations d'angle (17).

18. Rail profilé transversal pour la fixation d'une tôle en nid d'abeilles (20) selon l'une quelconque des revendications 15 à 17, caractérisé en ce que
a) il présente une rainure (15b) orientée longitudinalement, de forme en U en section transversale, avec des branches s'étendant parallèlement l'une à l'autre,
b) les deux branches présentent chacune un tenon (15c, d) orienté vers l'intérieur, décalé par rapport à l'autre et
c) en ce que l'écart opposé des deux tenons (15c, d) - mesuré comme la distance (15f) entre les deux plans, qui contiennent chacun l'extrémité des tenons (15c, d) et s'étendent parallèlement aux branches - est un peu plus petit que l'épaisseur (D) de la tôle en nid d'abeilles (20) à insérer dans la rainure (15b).

19. Procédé de fabrication d'un tableau, qui se compose d'une tôle en nid d'abeilles (20) entourée d'un cadre, selon l'une quelconque des revendications 1 à 18, caractérisé par les caractéristiques suivantes:
a) la tôle en nid d'abeilles (20) est poussée sur deux côtés opposés en biais dans une ouverture de rainure (15g, 16g) formée dans les tenons décalés (15c, d, 16c, d) de chaque rail profilé transversal (15, 16), de sorte que les plans des branches s'étendent suivant un certain angle par rapport à la surface de la tôle en nid d'abeilles (figure 4),
b) les deux rails profilés transversaux (15, 16) sont tournés, par enfoncement simultané (20a) des tenons (15c, d, 16c, d) dans la tôle en nid d'abeilles et sous tension de la tôle en nid d'abeilles (20) dans une mesure telle que les plans des branches s'étendent parallèlement aux surfaces de la tôle en nid d'abeilles (20) (figure 5),
c) les rails profilés latéraux (18, 19) pourvus de fixations d'angle à angle droit (17) sont pressés contre les côtés libres de la tôle en nid d'abeilles (20) élastique, à arêtes pointues, les extrémités libres des fixations à angle (17) venant en prise dans des canaux de rainure (15a, 16a) des rails profilés transversaux (15, 16), et les rails profilés latéraux (18, 19) en forme de U s'appliquent de manière à isoler des champs électromagnétiques et électrostatiques contre les profils découpés de la tôle en nid d'abeilles (20) et entourent en la guidant, la tôle en nid d'abeilles.
